# EUROPÄISCHE PATENTSCHRIFT

(11) **EP 0 962 284 B1**
(45) Veröffentlichungstag und Bekanntmachung des Hinweises auf die Patenterteilung: **14.11.2001**
(21) Anmeldenummer: 99109278.4
(22) Anmeldetag: 27.05.1999
(51) Int. Cl.: B24B 47/22, B24B 49/00, B28D 5/00

(54) **Verfahren und Vorrichtung zur Herstellung eines zylinderförmigen Einkristalls und Verfahren zum Abtrennen von Halbleiterscheiben**
Method and apparatus for manufacturing a cylindrical single crystal and method for slicing wafers
Procédé et dispositif pour la fabrication d'un monocristal cylindrique et procédé de tranchage de plaquettes semiconductrices

(30) Priorität: 04.06.1998 DE 19825051
(43) Veröffentlichungstag der Anmeldung: 08.12.1999
(73) Patentinhaber: Wacker Siltronic Gesellschaft für Halbleitermaterialien Aktiengesellschaft, 84489 Burghausen (DE)
(72) Erfinder: Ölkrug, Hans, Dr., 84529 Tittmoning (DE); Lundt, Holger, Dr., 84489 Burghausen (DE); Andrä, Christian, 84577 Tüssling (DE); Frumm, Josef, 83413 Fridolfing (DE)
(74) Vertreter: Rimböck, Karl-Heinz, Dr.

(56) Entgegenhaltungen:
- EP-A- 0 359 591
- EP-A- 0 743 140
- US-A- 4 710 259

## Beschreibung

Die Erfindung betrifft ein Verfahren und eine Vorrichtung zur Herstellung eines zylinderförmigen Einkristalls aus Halbleitermaterial mit möglichst geringer Fehlorientierung des Kristallgitters. Gegenstand der Erfindung ist ferner ein Verfahren zum Abtrennen von Halbleiterscheiben von zwei oder mehreren solcher Einkristalle mittels Drahtsägen.

Eine Schleifmaschine zum Verrunden stabförmiger Einkristalle ist in der EP-359591 A1 beschrieben.

Das Kristallgitter von zylinderförmigen Einkristallen aus Halbleitermaterial weist häufig eine bestimmte Fehlorientierung auf. Eine Fehlorientierung liegt vor, wenn die Kristallachse und die geometrische Achse des Einkristalls einen bestimmten Winkel einschließen. Die Kristallachse ist eine die kristallographische Orientierung des Kristallgitters bezeichnende Achse. Für die Herstellung von elektronischen Bauelementen werden insbesondere Kristalle aus Silicium benötigt, die beispielsweise eine <100>, <511>, <110> oder <111> Kristallorientierung aufweisen. Die Bestimmung der räumlichen Lage der Kristallachse erfolgt nach einer röntgenoptischen Methode, beispielsweise gemäß dem in der deutschen Normvorschrift DIN 50433 (Teil 1) beschriebenen Verfahren. Die geometrische Achse eines zylinderförmigen Einkristalls entspricht der durch die Mitte des Einkristalls führenden Längsachse des Einkristalls.

Üblicherweise muß jeder Einkristall untersucht werden, ob eine Fehlorientierung des Kristallgitters vorliegt, und die Schneidebenen durch den Einkristall beim Abtrennen von Halbleiterscheiben so gelegt werden, daß Halbleiterscheiben mit einer gewünschten Kristallorientierung entstehen. Dieses Verfahren, das beispielsweise in der US-4,710,259 beschrieben ist, ist besonders aufwendig und fehleranfällig.

Die Erfindung stellt ein Verfahren zur Verfügung, das zylinderförmige Einkristalle mit exakt orientierter Kristallachse zugänglich macht.

Gegenstand der Erfindung ist ein Verfahren zur Herstellung eines zylinderförmigen Einkristalls aus Halbleitermaterial, der ein Kristallgitter, eine Kristallachse und eine geometrische Achse aufweist, wobei die räumliche Lage der Kristallachse röntgenoptisch festgestellt wird. Das Verfahren ist gekennzeichnet durch die folgenden Schritte:
a) Herstellen eines Einkristalls mit einer Fehlorientierung des Kristallgitters von höchstens 1,5 °;
b) Anordnen des Einkristalls in einer Weise, daß der Einkristall um zwei Drehachsen gedreht werden kann, wobei die Drehachsen senkrecht zu zwei Ebenen liegen, die von zwei Achsen eines rechtwinkeligen Koordinatensystems mit den Achsen x, y und z aufgespannt werden;
c) Drehen des Einkristalls um die Drehachsen bis die Kristallachse parallel zur x,y-Ebene und parallel zur x,z-Ebene des Koordinatensystems liegt;
e) Anbringen von Druckstücken an den Stirnseiten des Einkristalls; und
f) Drehen des Einkristalls um die Kristallachse, wobei der Einkristall zwischen den Druckstücken in einer Schleifmaschine eingespannt ist, und Abschleifen einer Mantelfläche des Einkristalls bis der Einkristall einen bestimmten, einheitlichen Durchmesser aufweist.

Gegenstand der Erfindung ist weiterhin eine Vorrichtung, die zur Durchführung des Verfahrens geeignet ist. Die Vorrichtung ist gekennzeichnet durch
a) ein Röntgengoniometer zum Feststellen der räumlichen Lage einer Kristallachse des Einkristalls;
b) eine Dreheinrichtung, auf der der Einkristall gelagert und um zwei Drehachsen gedreht werden kann, wobei die Drehachsen senkrecht zu zwei Ebenen liegen, die von zwei Achsen eines rechtwinkeligen Koordinatensystems mit den Achsen x, y und z aufgespannt werden; und
c) Mittel zum Anbringen von Druckstücken an den Stirnseiten des Einkristalls.

Zur Durchführung des Verfahrens ist ein Einkristall bereitzustellen, der zweckmäßigerweise gemäß der Czochralski-Methode (CZ-Verfahren) oder durch Zonenziehen (FZ-Verfahren) hergestellt wurde. Zur Herstellung des Einkristalls wird ein Impfkristall benötigt, der vorzugsweise aus einkristallinem Material herausgetrennt wird. Bei der Gewinnung des Impfkristalls ist zu beachten, daß das Kristallgitter des Impfkristalls eine Fehlorientierung von höchstens 1,5 ° aufweist. Der auf dem Impfkristall aufwachsende Einkristall darf ebenfalls eine Fehlorientierung von höchstens 1,5 °, vorzugsweise 0,5 ° aufweisen, das heißt, der Winkel zwischen der geometrischen Achse des Einkristalls und der Kristallachse des Einkristalls darf den angegebenen Maximalwert nicht überschreiten.

Ein gemäß Schritt a) des Verfahrens hergestellter Einkristall wird erfindungsgemäß in einer Weise angeordnet, daß er um zwei Drehachsen gedreht werden kann, die senkrecht zu zwei Ebenen liegen, die von zwei Achsen eines rechtwinkeligen Koordinatensystems mit den Achsen x, y und z aufgespannt werden. In dieser Lage wird der Einkristall um die Drehachsen gedreht, bis die Kristallachse parallel zur x,y-Ebene und parallel zur x,z-Ebene des Koordinatensystems liegt. Die Drehachsen schneiden sich vorzugsweise in der Mitte L/2 des Einkristalls, wobei L die Länge des Einkristalls ist. Liegt der Schnittpunkt genau in der Mitte L/2 und sind die Länge L und der Enddurchmesser des geschliffenen Einkristalls vorgegeben, können bei dieser Lage des Schnittpunktes der Drehachsen Fehlorientierungen der Kristallachse beseitigt werden, die bei jeder anderen Lage des Schnittpunktes der Drehachsen nicht mehr zu korrigieren wären, ohne daß der vorgegebene Enddurchmesser beim Schleifen der Mantelfläche unterschritten werden müßte.

Das Verfahren und eine zur Durchführung des Verfahrens geeignete Vorrichtung werden nachfolgend unter Bezugnahme auf Figuren näher erläutert.
Fig.1 zeigt schematisch, wie ein Einkristall gemäß einer Ausführungsform des Verfahrens im Raum bewegt werden muß, um eine möglichst geringe Fehlorientierung des Kristallgitters zu erreichen;
in Fig.2 ist gezeigt, wie sich dieses Ziel gemäß einer anderen Ausführungsform des Verfahrens verwirklichen läßt.
In Fig.3 ist eine bevorzugte Vorrichtung zur Durchführung des erfindungsgemäßen Verfahrens dargestellt.

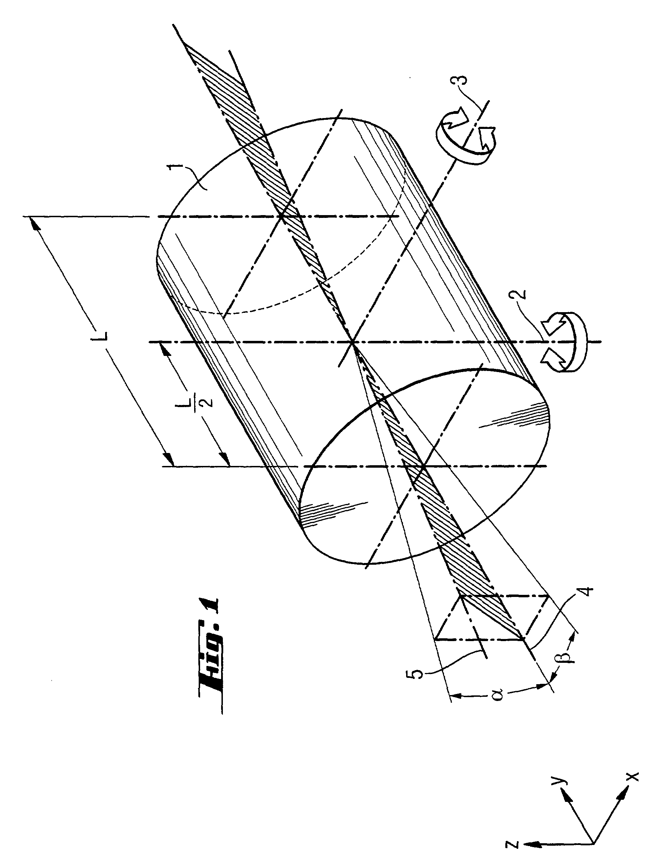

Bei der in Figur 1 gezeigten Verfahrensvariante wird der Einkristall 1 um die Drehachsen 2 und 3 gedreht, die einen 90°-Winkel einschließen und sich bei L/2 schneiden. Die Drehachse 2 liegt senkrecht zur x,y-Ebene des Koordinatensystems, die Drehachse 3 senkrecht zur y,z-Ebene. Die Achse 4 ist die geometrische Achse des Einkristalls. Die Drehachse 2 wird um einen, dem Winkel α entsprechenden Winkel, und die Drehachse 3 um einen, dem Winkel β entsprechenden Winkel gedreht. Die Lage der Kristallachse 5 im Koordinatensystem wird röntgenoptisch festgestellt. Zu diesem Zweck trifft der Strahl eines Röntgengoniometers an einer Stirnseite des Einkristalls auf. Das Drehen des Einkristalls kann automatisch geregelt erfolgen oder durch einen Operator vorgenommen werden. Als Regelgröße dient die Intensität der am Kristallgitter gestreuten Röntgenstrahlung. Das Röntgengoniometer wird vorzugsweise so justiert, daß die Intensität der registrierten Röntgenstrahlung beim Drehen des Einkristalls jeweils ein Maximum erreicht, wenn die Kristallachse parallel zur x,y-Ebene, beziehungsweise parallel zur x,z-Ebene ausgerichtet ist. Der Operator hat dann keine Mühe, den Einkristall in die gewünschte Position zu drehen.

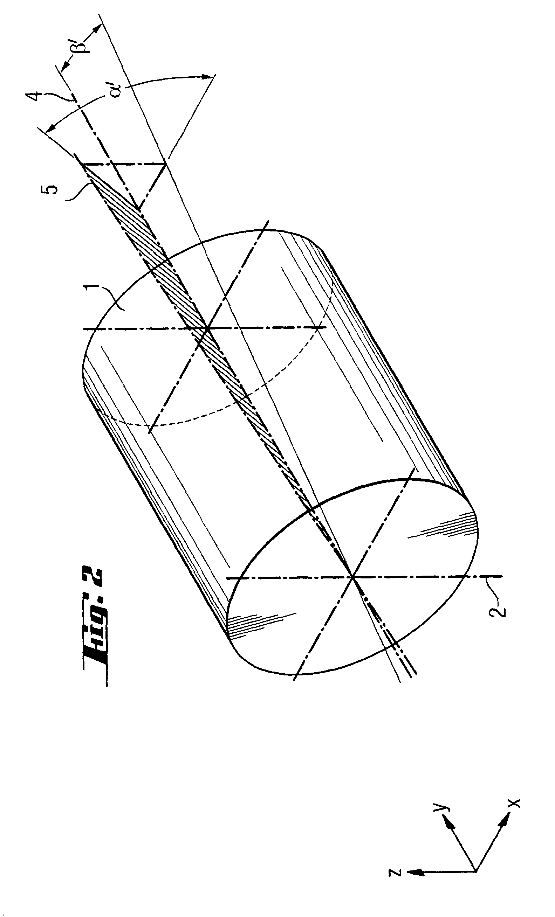

Bei der in Fig.2 gezeigten Verfahrensvariante wird der Einkristall zunächst um die geometrische Achse 4 gedreht, bis die Kristallachse 5 parallel zur x,y-Ebene liegt. Der Einkristall ist so angeordnet, daß die geometrische Achse senkrecht zur x,z-Ebene des Koordinatensystems liegt. Gemäß der Darstellung muß der Einkristall um einen Winkel α' gedreht werden. Anschließend wird der Einkristall 1 um einen Winkel β' gedreht. Als Drehachse wird eine Achse 2 gewählt, die senkrecht zur x,y-Ebene des Koordinatensystems liegt. Nach dem Drehen des Einkristalls ist die Kristallachse 5 parallel zur x,y-Ebene und parallel zur x,z-Ebene ausgerichtet.

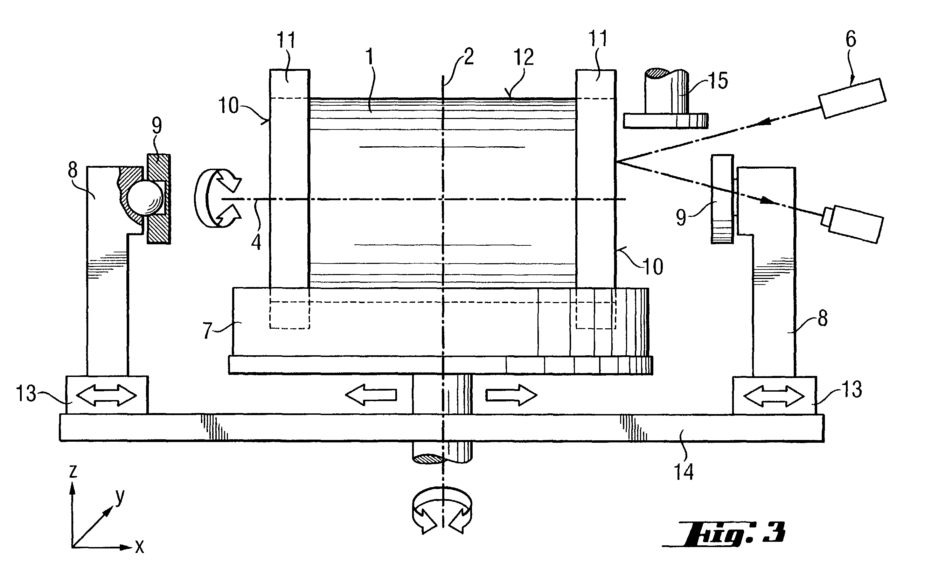

In Fig.3 ist eine Vorrichtung dargestellt, mit der ein Einkristall in der anhand von Fig.2 beschriebenen Weise gedreht werden kann. Die Vorrichtung umfaßt ein Röntgengoniometer 6, eine Dreheinrichtung 7 und Mittel 8 zum Anbringen von Druckstücken 9 an den Stirnseiten 10 des Einkristalls 1. Der Einkristall ist mit Hilfe von Zentrierringen 11 so auf der Dreheinrichtung gelagert, daß er um die geometrische Achse 4 und die Drehachse 2 drehbar ist. Besonders bevorzugt ist, Zentrierringe 11 zu verwenden, deren Innenradius wie der Innenradius einer Irisblende verengt werden kann. Die geometrische Achse 4 liegt senkrecht zur y,z-Ebene des Koordinatensystems, die Drehachse 2 senkrecht zu dessen x,y-Ebene. Die Dreheinrichtung ist auf einem Tisch 14 angeordnet und kann auf diesem, beispielsweise zum Justieren des Röntgengoniometers, linear verschoben werden. Zur Erleichterung des Justierens kann eine Anschlagrolle 15 bereitgestellt werden, die so angeordnet ist, daß eine optimale Justierung vorliegt, sobald die Stirnseite 10 des Einkristalls die Anschlagrolle beim linearen Verschieben der Dreheinrichtung berührt.

Es ist klar, daß die Vorrichtung ohne weiteres so abgewandelt werden kann, daß der Einkristall mit der Dreheinrichtung statt um die geometrische Achse 4 um eine Drehachse gedreht werden kann, die senkrecht zur x,z-Ebene des Koordinatensystems liegt und die andere Drehachse vorzugsweise bei L/2 schneidet. In diesem Fall kann mit der Vorrichtung die Verfahrensvariante gemäß Fig.1 durchgeführt werden.

Wenn die Kristallachse in der gewünschten Weise ausgerichtet ist, werden Druckstücke 9 an die Stirnseiten 10 des Einkristalls herangeführt und an diesen fixiert, vorzugsweise an diese aufgeklebt. Druckstücke sind Halterungen, zwischen denen der Einkristall beim Schleifen der Mantelfläche in einer Schleifmaschine eingespannt ist. Die Druckstücke werden so an die Stirnseiten gesetzt, daß sie von der Kristallachse zentrisch durchdrungen werden und die Kristallachse während des Schleifens der Mantelfläche des Einkristalls auch Rotationsachse ist. Zum Ansetzen der Druckstücke verfügt die Vorrichtung über einen Vorschub 13, der die Druckstücke entlang der Kristallachse linear gegen die Stirnseiten verschiebt. Es hat sich als vorteilhaft erwiesen, daß die Druckstücke von einer magnetisierten Kugel gehalten werden, bevor sie auf den Stirnseiten des Einkristalls befestigt werden. Die Druckstücke können dadurch auch dann noch exakt positioniert werden, wenn die Stirnseiten nicht genau parallel zur y,z-Ebene des Koordinatensystems ausgerichtet sein sollten.

Zum Schluß des Verfahrens wird die Mantelfläche 12 des Einkristalls geschliffen, bis der Einkristall einen vorbestimmten, einheitlichen Enddurchmesser aufweist.

Die Erfindung ermöglicht, Einkristalle, die auf die beschriebene Weise hergestellt wurden, einfach und effektiv zu Halbleiterscheiben zu zerteilen. Die Halbleiterscheiben werden vorzugsweise mittels einer Drahtsäge und unter Ausnutzung der gesamten Breite eines als Sägewerkzeug eingesetzten Drahtgatters der Drahtsäge von einem Einkristall mit ausreichender Länge oder von zwei oder mehreren kürzeren Einkristallen mit einer der Breite des Drahtgatters möglichst entsprechenden Gesamtlänge abgetrennt. Die dazu notwendigen Vorarbeiten, insbesondere im Hinblick auf das richtige Ausrichten von zwei oder mehreren Einkristallen sind denkbar einfach, wobei Fehler kaum gemacht werden können. Die Einkristalle mit einer der Breite des Drahtgatters möglichst entsprechenden Gesamtlänge werden auf einer ebenen Unterlage entlang einer geraden Führungskante nebeneinander so angeordnet, daß die Mantelfläche jedes Einkristalls an der Führungskante anliegt. Die Führungskante dient zur raschen und einfachen Ausrichtung der Einkristalle. Sie kann wieder entfernt werden, sobald die Einkristalle auf der Unterlage fixiert sind. Die Einkristalle können beispielsweise auf die Unterlage geklebt werden und bleiben auch nach dem Entfernen der Führungskante entlang einer geraden Linie ausgerichtet. Durch präzises Einstellen des Winkels zwischen den Drähten des Drahtgatters der Drahtsäge und dieser Linie während des Abtrennens der Halbleiterscheiben, können Halbleiterscheiben mit genau vorbestimmter Kristallorientierung erzeugt werden. Beträgt der Winkel 90°, entspricht die Kristallorientierung genau der Kristallorientierung des zylinderförmigen Einkristalls. Mit einem von 90° abweichendem Winkel können Fehlorientierungen gezielt eingestellt werden.

## Patentansprüche

1. Verfahren zur Herstellung eines zylinderförmigen Einkristalls (1) aus Halbleitermaterial, der ein Kristallgitter, eine Kristallachse (5) und eine geometrische Achse (4) aufweist, wobei die räumliche Lage der Kristallachse röntgenoptisch festgestellt wird, das **gekennzeichnet ist durch**
a) Herstellen eines Einkristalls mit einer Fehlorientierung des Kristallgitters von höchstens 1,5 °;
b) Anordnen des Einkristalls in einer Weise, daß der Einkristall um zwei Drehachsen (2, 3) gedreht werden kann, wobei die Drehachsen senkrecht zu zwei Ebenen liegen, die von zwei Achsen eines rechtwinkeligen Koordinatensystems mit den Achsen x, y und z aufgespannt werden;
c) Drehen des Einkristalls um die Drehachsen bis die Kristallachse (5) parallel zur x,y-Ebene und parallel zur x,z-Ebene des Koordinatensystems liegt;
e) Anbringen von Druckstücken (9) an den Stirnseiten (10) des Einkristalls; und
f) Drehen des Einkristalls um die Kristallachse (5), wobei der Einkristall zwischen den Druckstücken (9) in einer Schleifmaschine eingespannt ist, und Abschleifen einer Mantelfläche (12) des Einkristalls bis der Einkristall einen bestimmten, einheitlichen Durchmesser aufweist.

2. Verfahren nach Anspruch 1, **dadurch gekennzeichnet, daß** eine Achse als Drehachse gewählt wird, die senkrecht zur x,y-Ebene des Koordinatensystems liegt, und eine Achse als Drehachse gewählt wird, die senkrecht zur x,z-Ebene des Koordinatensystems liegt.

3. Verfahren nach Anspruch 1, **dadurch gekennzeichnet, daß** die geometrische Achse (4) des Einkristalls als Drehachse gewählt wird und eine Achse als Drehachse gewählt wird, die senkrecht zur x,y-Ebene des Koordinatensystems liegt.

4. Verfahren nach einem der Ansprüche 1 bis 3, **dadurch gekennzeichnet, daß** der Einkristall derartig angeordnet wird, daß sich die Drehachsen (2, 3) in der Mitte L/2 des Einkristalls schneiden, wobei L die Länge des Einkristalls ist.

5. Verfahren nach einem der Ansprüche 1 bis 4, **dadurch gekennzeichnet, daß** ein Impfkristall, dessen Kristallgitter um höchstens 1,5 ° fehlorientiert ist, aus einem Mutterkristall herausgetrennt wird und der Einkristall auf dem Impfkristall gezüchtet wird.

6. Verfahren zur Herstellung von Halbleiterscheiben mittels Drahtsägen, wobei zwei oder mehrere zylindrische Einkristalle gleichzeitig von einem Drahtgatter einer Drahtsäge bearbeitet werden, **dadurch gekennzeichnet, daß** die Einkristalle nach einem Verfahren gemäß einem der Ansprüche 1 bis 5 hergestellt werden und gleiche Durchmesser und gleiche Kristallorientierung haben, und beim Drahtsägen in einer Weise nebeneinander angeordnet sind, daß die Einkristalle mit den Mantelflächen an einer geraden Führungskante anliegen würden.

7. Vorrichtung zur Herstellung eines zylinderförmigen Einkristalls aus Halbleitermaterial mit möglichst geringer Fehlorientierung des Kristallgitters, **gekennzeichnet durch**
a) ein Röntgengoniometer (6) zum Feststellen der räumlichen Lage einer Kristallachse des Einkristalls;
b) eine Dreheinrichtung (7), auf der der Einkristall gelagert und um zwei Drehachsen gedreht werden kann, wobei die Drehachsen senkrecht zu zwei Ebenen liegen, die von zwei Achsen eines rechtwinkeligen Koordinatensystems mit den Achsen x, y und z aufgespannt werden; und
c) Mittel (8) zum Anbringen von Druckstücken (9) an den Stirnseiten (10) des Einkristalls.

8. Vorrichtung nach Anspruch 7, **gekennzeichnet durch** einen Tisch (14), auf dem die Dreheinrichtung linear bewegbar montiert ist.

9. Vorrichtung nach Anspruch 7 oder Anspruch 8, **gekennzeichnet durch** Mittel, die sicherstellen, daß das Röntgengoniometer (6) in gewünschter Weise justiert ist.

10. Vorrichtung nach einem der Ansprüche 7 bis 9, **gekennzeichnet durch** Zentrierringe (11), die um eine Mantelfläche des Einkristalls gelegt sind.

## Claims

1. Process for producing a cylindrical single crystal (1) of semiconductor material, which has a crystal lattice, a crystal axis (5) and a geometrical axis (4), the spatial position of the crystal axis being established by X-ray optics, **characterized in that**
a) a single crystal with an alignment error of the crystal lattice equal to at most 1.5° is produced;
b) the single crystal is arranged in such a way that the single crystal can be rotated about two axes (2,3) of rotation, the axes of rotation being perpendicular to two planes that are spanned by two axes of an orthogonal coordinate system with axes x, y and z;
c) the single crystal is rotated about the axes of rotation until the crystal axis (5) is parallel to the x,y plane and parallel to the x,z plane of the coordinate system;
e) pads (9) are fitted to the ends (10) of the single crystal; and
f) the single crystal is rotated about the crystal axis (5), the single crystal being clamped between the pads (9) in a grinding machine, and a lateral surface (12) of the single crystal is ground until the single crystal has a specific uniform diameter.

2. Process according to Claim 1, **characterized in that** one axis which is perpendicular to the x,y plane of the coordinate system is chosen as an axis of rotation, and one axis which is perpendicular to the x,z plane of the coordinate system is chosen as an axis of rotation.

3. Process according to Claim 1, **characterized in that** the geometrical axis (4) of the single crystal is chosen as an axis of rotation, and one axis which is perpendicular to the x,y plane of the coordinate system is chosen as an axis of rotation.

4. Process according to one of Claims 1 to 3, **characterized in that** the single crystal is arranged in such a way that the axes (2,3) of rotation intersect at the middle L/2 of the single crystal, L being the length of the single crystal.

5. Process according to one of Claims 1 to 4, **characterized in that** a seed crystal, whose crystal lattice has an alignment error of at most 1.5°, is detached from a parent crystal and the single crystal is grown on the seed crystal.

6. Process for producing semiconductor wafers by means of wire sawing, two or more cylindrical single crystals being processed at the same time by a wire guide of a wire saw, **characterized in that** the single crystals are produced using a process according to one of Claims 1 to 5 and are of the same diameter and the same crystal orientation, and during the wire sawing are arranged next to one another in such a way that the single crystals would bear via their lateral surfaces on a straight guide edge.

7. Device for producing a cylindrical single crystal of semiconductor material with the smallest possible alignment error of the crystal lattice, **characterized by**
a) a X-ray goniometer (6) for establishing the spatial position of a crystal axis of the single crystal;
b) a rotating device (7), on which the single crystal is mounted and which can be rotated about two axes of rotation, the axes of rotation being perpendicular to two planes that are spanned by two axes of an orthogonal coordinate system with axes x, y and z; and
c) means (8) for fitting pads (9) to the ends (10) of the single crystal.

8. Device according to Claim 7, **characterized by** a table (14) on which the rotating device is mounted so that it can move in a straight line.

9. Device according to Claim 7 or Claim 8, **characterized by** means which ensure that the X-ray goniometer (6) is aligned in the desired way.

10. Device according to one of Claims 7 to 9, **characterized by** centering rings which are placed around a lateral surface of the single crystal.

## Revendications

1. Procédé de fabrication d'un monocristal cylindrique (1) en matériau semiconducteur, qui présente une grille de cristal, un axe de cristal (5) et un axe géométrique (4), la position dans l'espace de l'axe du cristal étant déterminée de manière optique par rayons X, qui se **caractérise par**
a) La fabrication du monocristal avec une erreur d'orientation de la grille du cristal de 1,5° au maximum ;
b) L'arrangement du monocristal de telle manière que le monocristal puisse être tourné autour de deux axes de rotation (2, 3), les axes de rotation étant perpendiculaires à deux plans qui sont fixés par deux axes d'un système de coordonnées à angle droit composé des axes x, y et z ;
c) La rotation du monocristal autour des axes de rotation jusqu'à ce que l'axe du cristal (5) soit parallèle au plan x, y et parallèle au plan x, z du système de coordonnées ;
e) La pose d'éléments presseurs (9) sur les faces frontales (10) du monocristal ; et
f) La rotation du monocristal autour de l'axe du cristal (5), le monocristal étant serré dans une rectifieuse entre les éléments presseurs (9), et rectification d'une surface d'enveloppe (12) du monocristal jusqu'à ce que le monocristal présente un diamètre uniforme donné.

2. Procédé selon la revendication 1, **caractérisé en ce qu'**un axe choisi comme axe de rotation est perpendiculaire au plan x, y du système de coordonnées et qu'un axe choisi comme axe de rotation est perpendiculaire au plan y, z du système de coordonnées.

3. Procédé selon la revendication 1, **caractérisé en ce que** l'axe géométrique (4) du monocristal est choisi comme axe de rotation et qu'un axe choisi comme axe de rotation est perpendiculaire au plan x, y du système de coordonnées.

4. Procédé selon l'une des revendications 1 à 3, **caractérisé en ce que** le monocristal est disposé de telle manière que les axes de rotation (2, 3) se croisent au centre L/2 du monocristal, la longueur L étant la longueur du monocristal.

5. Procédé selon l'une des revendications 1 à 4, **caractérisé en ce qu'**un germe dont la grille de cristal présente une erreur d'orientation maximale de 1,5 ° est extrait d'un cristal-mère et que le monocristal est cultivé sur le germe.

6. Procédé de fabrication de galettes en semiconducteur avec des scies à fils, deux monocristaux cylindriques ou plus étant usinés simultanément par un treillis métallique d'une scie à fils, **caractérisé en ce que** les monocristaux sont fabriqués d'après l'un des procédés selon l'une des revendications 1 à 5 et présentent le même diamètre et la même orientation, et sont disposés les uns à côté des autres lors du sciage aux fils de manière à ce que les surfaces d'enveloppe des monocristaux reposent sur un bord de guidage droit.

7. Appareillage pour fabriquer un monocristal cylindrique en matériau semiconducteur ayant une erreur d'orientation de la grille du cristal la plus faible possible, **caractérisé par**
a) Un goniomètre à rayons X (6) pour déterminer la position dans l'espace d'un axe de cristal du monocristal ;
b) Un dispositif de rotation sur lequel le monocristal peut être déposé et tourner autour de deux axes de rotation, les axes de rotation étant perpendiculaires à deux plans qui sont fixés par deux axes d'un système de coordonnées à angle droit composé des axes x, y et z ; et
c) Des moyens (8) pour appliquer des éléments presseurs (9) sur les faces frontales (10) du monocristal.

8. Appareillage selon la revendication 7, **caractérisé par** une table (14) sur laquelle le dispositif de rotation est fixé de manière à pouvoir se déplacer dans le sens linéaire.

9. Appareillage selon la revendication 7 ou la revendication 8, **caractérisé par** des moyens qui garantissent que le goniomètre à rayons X (6) est réglé de la manière souhaitée.

10. Appareillage selon l'une des revendications 7 à 9, **caractérisé par** des bagues de centrage (11) qui sont posées autour d'une surface d'enveloppe du monocristal.
